# EUROPEAN PATENT APPLICATION

(11) **EP 4 561 301 A1**
(43) Date of publication of application: **28.05.2025**
(21) Application number: 24214681.9
(22) Date of filing: 22.11.2024
(51) Int. Cl.: H10F 39/00

(54) **SINGLE-PHOTON AVALANCHE DIODE PIXEL ARRAY AND METHOD FOR FABRICATING THE SAME**

(30) Priority: 24.11.2023 KR 20230166041; 08.11.2024 KR 20240157618
(71) Applicant: LX Semicon Co., Ltd., Daejeon 34027 (KR)
(72) Inventor: Jang, Hoon, Daejeon 34027 (KR)
(74) Representative: Goddar, Heinz J.

(57) **Abstract**

A single-photon avalanche diode pixel array includes a substrate doped with a first conductive type dopant and having a plurality of pixels formed thereon, a pixel isolation structure for electrically isolating the plurality of pixels from each other, a first highly doped region provided by highly doping the first conductive type dopant at a first surface of the substrate, a trench disposed to have a predetermined depth from the first surface of the substrate toward a second surface of the substrate, a well region provided below the trench to be spaced apart from the first highly doped region by a predetermined distance and provided by doping a second conductive type dopant opposite to the first conductive type dopant to form an avalanche multiplication region, and a second highly doped region formed by highly doping the second conductive type dopant at a surface of the well region exposed by the trench.

## Description

### CROSS-REFERENCE TO RELATED APPLICATIONS

This application claims the priorities of Korean Patent Applications No. 10-2023-0166041 filed on November 24, 2023 and No. 10-2024-0157618 filed on November 8, 2024, which are hereby incorporated by reference in their entirety.

### BACKGROUND

### Field of the Disclosure

The present disclosure relates to an image sensor, and more particularly, for example, without limitation, to an image sensor including a single-photon avalanche diode pixel array.

### Description of the Background

TOF (Time of Flight) technology irradiates light in the form of pulses from a light source disposed inside or near the sensor, receives the reflected light, measures the time between the time when the light is irradiated and the time when the reflected light is received, and extracts a distance based on the principle of constancy of light velocity. To accurately measure TOF, a very sensitive photoelectric conversion element is required because a reaction has to occur as soon as the light reaches the light-receiving element. To this end, research on the Single-Photon Avalanche Diode (SPAD) capable of manufacturing using CMOS process technology is actively being conducted.

The single-photon avalanche diode is a structure in which repeats operation and recovery (quenching) in the Geiger mode by applying a reverse voltage much higher than the breakdown voltage of the single-photon avalanche diode, also referred to as avalanche voltage, to a photodiode. Since a reverse voltage exceeding the breakdown voltage is applied to the single-photon avalanche diode, electron avalanche caused by carriers generated by photoelectric conversion occurs, and the single-photon avalanche diode enters a breakdown state. As a result, multiplication of carriers by photoelectric conversion occurs, and the sensitivity in an imaging device may be improved.

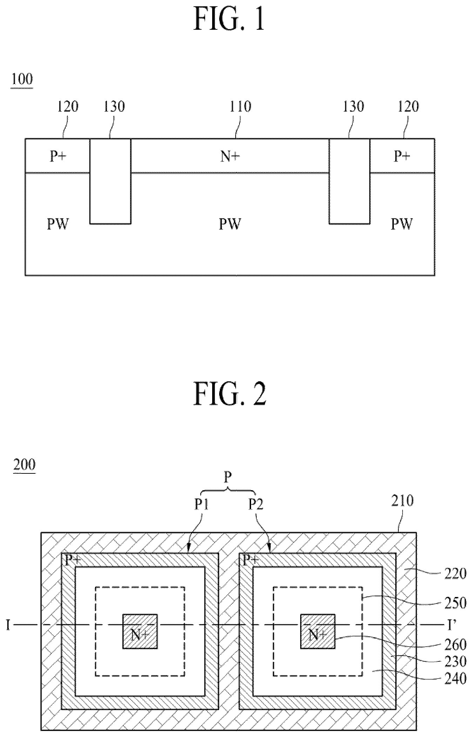

However, in a general single-photon avalanche diode pixel array 100 as illustrated in FIG. 1, since the cathode region 110 to which the cathode electrode is connected and the anode region 120 to which the anode electrode is connected are arranged in a planar type and a high voltage is applied, a guard ring 130 is required for electrical isolation of the cathode region 110 and the anode region 120. However, since the guard ring 130 occupies a large area, there is a problem in that miniaturization of the pixel is limited.

### SUMMARY

The present disclosure has been made in view of the above problems, and it is an aspect of the present disclosure to provide a single-photon avalanche diode pixel array capable of miniaturization and a method for manufacturing the same.

It is another aspect of the present disclosure to provide a single-photon avalanche diode pixel array and a method for manufacturing the same, which may reduce the occurrence of leakage current between pixels.

To achieve these and other advantages and in accordance with the purpose of the disclosure, as embodied and broadly described herein, there is provided a single-photon avalanche diode pixel array including a substrate doped with a first conductive type dopant and having a plurality of pixels formed thereon, a pixel isolation structure for electrically isolating the plurality of pixels from each other, a first highly doped region provided by highly doping the first conductive type dopant at a first surface of the substrate, a trench disposed to have a predetermined depth from the first surface of the substrate toward a second surface of the substrate, a well region provided below the trench to be spaced apart from the first highly doped region by a predetermined distance and provided by doping a second conductive type dopant opposite to the first conductive type dopant to form an avalanche multiplication region, and a second highly doped region formed by highly doping the second conductive type dopant at a surface of the well region exposed by the trench.

In accordance with another aspect of the present disclosure, there is provided a method for manufacturing a single-photon avalanche diode pixel array including forming a pixel isolation structure for electrically isolating the plurality of pixels from each other in a substrate, the substrate being doped with a first conductive type dopant, forming a trench to have a predetermined depth from a first surface of the substrate toward a second surface of the substrate, forming a well region between a bottom surface of the trench and the second surface of the substrate by doping a second conductive type dopant opposite to the first conductive type dopant to form an avalanche multiplication region, and forming a first highly doped region by highly doping the first conductive type dopant at the first surface of the substrate and forming a second highly doped region by highly doping the second conductive type dopant at a surface of the well region exposed by the trench.

It is to be understood that both the foregoing general description and the following detailed description are exemplary and explanatory, and are intended to provide further explanation of the inventive concepts as claimed.

In addition to the effects of the present disclosure as mentioned above, additional advantages and features of the present disclosure will be clearly understood by those skilled in the art from the above description of the present disclosure.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 illustrates a pixel structure of a general single-photon avalanche diode;
FIG. 2 is a plan view of a pixel array of a single-photon avalanche diode according to one exemplary aspect of the present disclosure;
FIG. 3 is a cross-sectional view taken along line I-I' of the pixel array illustrated in FIG. 2;
FIG. 4A and FIG. 4B illustrate an electronic device including an image sensor having a single-photon avalanche diode pixel array according to one example aspect of the present disclosure;
FIG. 5 is a block diagram of an image sensor having a single-photon avalanche diode pixel array as illustrated in FIG. 2 and FIG. 3; and
FIG. 6A to FIG. 6F are process cross-sectional views showing a method for manufacturing a single-photon avalanche diode pixel array according to one exemplary aspect of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to aspects of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and implementation methods thereof will be clarified through following exemplary aspects described with reference to the accompanying drawings. The present disclosure may, however, be embodied in different forms and should not be construed as limited to the exemplary aspects set forth herein. Rather, these exemplary aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing exemplary aspects of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In a case where "include, " "have, " "comprise, " "contain, " "constitute, " "make up of, " "formed of, " and "consist of" described in the present specification are used, another part may be added unless 'only~' is used. The terms of a singular form may include plural forms unless referred to the contrary.

The shapes, sizes, dimensions (e.g., length, width, height, thickness, radius, diameter, area, etc.), ratios, angles, numbers of elements, and the like illustrated in the accompanying drawings for describing the exemplary aspects of the present disclosure are merely examples, and the present disclosure is not limited thereto. Like reference numerals generally denote like elements throughout the specification.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

In construing an element, the element is construed as including an error range although there is no explicit description.

In describing a position relationship, for example, when a position relation between two parts is described as "on", "above", "over", "below", "under", "beside", "beneath", "near", "close to, " "adjacent to", "on a side of', "next", one or more other parts may be disposed between the two parts unless 'just' or 'direct' is used.

Spatially relative terms, such as "under, " "below, " "beneath", "lower, " "over, " "upper" and the like, may be used herein for ease of description to describe one element or feature's relationship to another element (s) or feature (s) as illustrated in the figures. It will be understood that the spatially relative terms may encompass different orientations of an element in use or operation in addition to the orientation depicted in the figures. For example, if an element in the figures is inverted, elements described as "below" or "beneath" other elements or features would then be oriented "over" the other elements or features. Thus, the exemplary term "below" may encompass both an orientation of below and above. Similarly, the exemplary term "above" or "over" may encompass both an orientation of "above" and "below".

When an element or layer is disposed "on" another element or layer, another layer or another element may be interposed directly on the other element or therebetween.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", "A", "B", " (A) ", or " (B) " etc. may be used herein to describe various elements, these elements should not be limited by these terms. These terms are only used to distinguish one element from another. Accordingly, a first element mentioned hereinafter could be termed a second element without departing from the scope of the present disclosure.

The term "at least one" should be understood as including any and all combinations of one or more of the associated listed items. For example, the meaning of "at least one of a first item, a second item, and a third item" denotes each of the first item, the second item, and the third item as well as the combination of all items proposed from two or more of the first item, the second item, and the third item.

Features of various exemplary aspects of the present disclosure may be partially or overall coupled to or combined with each other and may be variously inter-operated or combined with each other and driven technically as those skilled in the art may sufficiently understand. The exemplary aspects of the present disclosure may be carried out independently from each other, or may be carried out together in co-dependent relationship.

Hereinafter, exemplary aspects of the present disclosure will be described in detail with reference to the accompanying drawings.

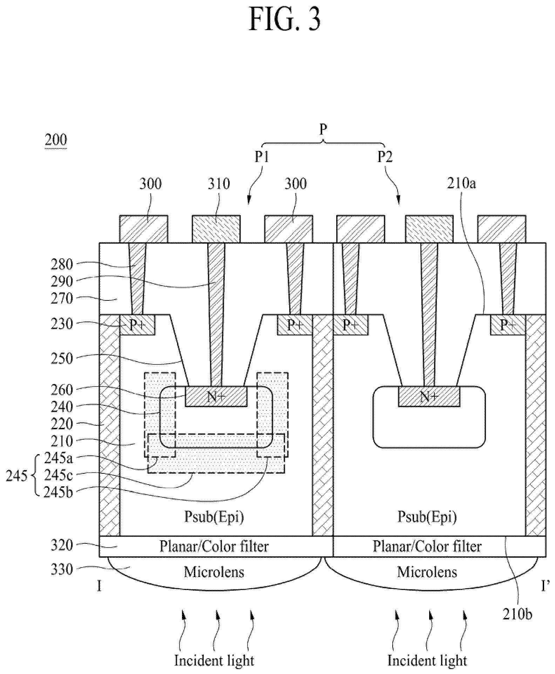

FIG. 2 is a plan view of a pixel array of a single-photon avalanche diode according to one exemplary aspect of the present disclosure and FIG. 3 is a cross-sectional view taken along line I-I' of the pixel array illustrated in FIG. 2.

As illustrated in FIGS. 2 and 3, a single-photon avalanche diode pixel array 200 according to one exemplary aspect of the present disclosure includes a substrate 210 on which a plurality of pixels P1 and P2 are formed. The substrate 210 has a first surface 210a and a second surface 210b. In one aspect, the first surface 210a of the substrate 210 may be a surface on which the light is incident from the outside and the second surface 210b of the substrate 210 may be an opposite surface of the first surface 210a.

The substrate 210 is a region lowly doped with a first conductive type dopant or a second conductive type dopant and may be formed by epitaxial growth. When the substrate 210 is doped with the first conductive type dopant, a region forming a PN junction with a well region 240 formed by doping with the second conductive type dopant opposite to the first conductive type dopant in the substrate 210 becomes an avalanche multiplication region.

In one aspect, the first conductive type dopant may be a P-type dopant and the second conductive type dopant may be an N-type dopant. However, in another aspect, the first conductive type dopant may be the N-type dopant and the second conductive type dopant may be the P-type dopant.

When the first conductive type dopant is the P-type dopant and the second conductive type dopant is the N-type dopant, the P-type dopant may include at least one of Boron, Aluminum, Gallium, and Indium, and the N-type dopant may include at least one of Phosphorus, Arsenic, and Stibium.

A pixel isolation structure 220 is formed in the substrate 210 to electrically isolate the pixels P1 and P2 from each other. In this aspect, a pixel area in which each pixel P1 and P2 may be formed is defined by the pixel isolation structure 220, and the pixels P1 and P2 formed in each pixel area are electrically isolated from each other by the pixel isolation structure 220. In one aspect, the pixel isolation structure 220 may be extended from the first surface 210a of the substrate 210 to the second surface 210b of the substrate 210.

In one aspect, the pixel isolation structure 220 may be formed as a deep trench isolation DTI structure formed by filling an insulating layer in a deep trench formed by penetrating the substrate 210 from the first surface 210a of the substrate 210 toward the second surface 210b of the substrate 210. s

In this way, according to the present disclosure, since the pixel isolation structure 220 for isolating the pixels P1 and P2 is formed continuously from the first surface 210a of the substrate 210 to the second surface 210b of the substrate (210), the occurrence of leakage current between adjacent pixels P1 and P2 may be prevented.

A first highly doped region 230 is formed by highly doping with the first conductive type dopant at the first surface 210a of the substrate 210. The first highly doped region 230 may be formed under the first surface 210a of the substrate 210 to have a predetermined thickness. The first highly doped region 230 may be an anode region of a single-photon avalanche diode.

In one aspect, as illustrated in FIG. 2, the first highly doped region 230 may be formed to be surrounded by the pixel isolation structure 220 in a plan view. In this aspect, the pixel isolation structure 220 formed in the substrate 210 may have a closed loop shape that surrounds the first highly doped region 230 in a plan view.

The well region 240 is formed within the substrate 210 by lowly doping the second conductive type dopant opposite to the first conductive type dopant. The well region 240 may be formed within the substrate 210 to be spaced apart from the first highly doped region 230 toward the second surface 210b of the substrate 210 by a predetermined distance. In this aspect, as described above, a region formed by doping the first conductive type dopant within the substrate 210 and the well region 240 formed by doping the second conductive type dopant form the PN junction, thereby forming an avalanche multiplication region 245.

That is, a first avalanche multiplication region 245a is formed on a first side 240a of the well region 240, a second avalanche multiplication region 245b is formed on a second side 240b facing the first side 240a, and a third avalanche multiplication region 245c is formed on a third side 240c connecting the first side 240a and the second side 240b.

The avalanche multiplication region 245 is a region where multiplication of electrons and holes occurs. In the avalanche multiplication region 245, a very strong electric field is formed in the reverse bias state, so that electrons may move quickly. Therefore, an electron-hole pair generated by a single photon generates additional electrons, and the generated electrons are accelerated by the electric field to collide with other atoms, and the process of generating additional electron-hole pairs occurs in a chain, thereby generating a very high current.

Due to the avalanche multiplication region 245, the single-photon avalanche diode is capable of single-photon detection, and thus may detect extremely low light signals, and may be particularly usefully applied to sensing in low-light environments.

In one aspect, as illustrated in FIG. 2, the well region 240 may be formed in a shape surrounded by the first highly doped region 230. That is, the first highly doped region 230 may be formed to have a closed loop shape surrounding the well region 240.

A trench 250 is formed at the first surface 210a of the substrate 210 to have a predetermined depth toward the second surface 210b of the substrate 210. The well region 240 may be formed below the trench 250 by doping the second conductive type dopant through a bottom surface of the trench 250. In one aspect, since the pixel isolation structure 220 is formed continuously from the first surface 210a of the substrate 210 to the second surface 210b of the substrate 210, the trench 250 formed to have the predetermined depth from the first surface 210a of the substrate 210 toward the second surface 210b of the substrate 210 may be shorter than the pixel isolation structure 220.

A second highly doped region 260 is formed at a surface of the well region 240 exposed by the trench 250 by highly doping the second conductive type dopant. The second highly doped region 260 may be a cathode region of the single-photon avalanche diode.

That is, in the single-photon avalanche diode pixel array 200 according to one exemplary aspect of the present disclosure, the second highly doped region 260, which may be the cathode region, may be formed by highly doping the second conductive type dopant at the surface of the well region 240 exposed by the trench 250 formed through selective etching of the substrate 210. Thus, the second highly doped region 260 which may be the cathode region and the first highly doped region 230 which may be the anode region may be disposed in a vertical structure.

Accordingly, in the single-photon avalanche diode pixel array 200 according to one exemplary aspect of the present disclosure, a guard ring required for isolation of the anode region and the cathode region in a general single-photon avalanche diode is not required, so that pixel miniaturization is possible.

In the above-described aspect, the position at which the second highly doped region 260 is formed within the substrate 210 may be adjusted according to the depth of the trench 250. For example, the deeper the depth of the trench 250, the further the second highly doped region 260 may be formed from the first highly doped region 230, while the shallower the depth of the trench 250, the closer the second highly doped region 260 may be formed from the first highly doped region 230.

In this aspect, the depth of the trench 250 may be determined to be inversely proportional to the pitch of the pixels P1 and P2. For example, as the pitch of the pixels P1 and P2 decreases, the vertical distance between the first highly doped region 230 and the second highly doped region 260 should be longer, and thus the depth of the trench 250 is formed deeper. On the contrary, as the pitch of the pixels P1 and P2 increases, the vertical distance between the first highly doped region 230 and the second highly doped region 260 may be shorter, and thus the depth of the trench 250 may be formed shallower.

Meanwhile, as illustrated in FIG. 2, the second highly doped region 260 may be formed to be surrounded by the first highly doped region 230 in a plan view. In this aspect, the first highly doped region 230 may be formed to have a closed loop shape surrounding the second highly doped region 260.

An insulating layer 270 is formed on the first surface 210a of the substrate 210 and inside the trench 250. In one aspect, the insulating layer 270 may include an oxide such as SiO2.

A first contact portion 280 and a second contact portion 290 may be formed in the insulating layer 270. The first contact portion 280 is formed to be connected to the first highly doped region 230 though the insulating layer 270. The second contact portion 290 is formed to be connected to the second highly doped region 260 though the insulating layer 270. In addition, a first metal pad 300 is formed on the first contact portion 280 to electrically connect the first contact portion 280 and a driving circuit of an image sensor. A second metal pad 310 is formed on the second contact portion 290 to electrically connect the second contact portion 290 and the driving circuit.

In the above-described aspect, the first contact portion 280 and the first metal pad 300 may constitute an anode electrode unit, and the second contact portion 290 and the second metal pad 310 may constitute a cathode electrode unit. In this aspect, the driving circuit may be a quench circuit or an output circuit (ROIC: Read Out Integrated Circuit). The quench circuit is used to cut off an avalanche effect and reset a single-photon avalanche diode pixel. The output circuit receives and transmits a signal current.

Meanwhile, a color filter 320 may be disposed for each pixel P1 and P2 on the first surface 210b of the substrate 210. Each color filter 320 may be color filter of different colors for each pixel P1 and P2. For example, the color filter of the first pixel P1 may be a red color filter and the color filter of the second pixel P2 may be a green color filter.

However, it is not limited thereto, and the number of pixels corresponding to one color filter 320 may be variously modified. In one exemplary aspect, pixels in an N x M array (N and M are integers greater than 1) may correspond to one color filter 320. For example, when N and M are 2, four pixels may correspond to one color filter 320.

A micro lens 330 is arranged on each color filter 320. The micro lens 330 is disposed on the color filter 320 and collect light incident from the outside. The micro lens 330 may be arranged to correspond to each pixel P. In this aspect, one micro lens 330 may be arranged on one pixel P.

For example, when one color filter 320 is arranged to correspond to one pixel P, the ratio of the number of color filters 320 to the number of micro lenses 330 may be 1: 1.

However, it is not limited thereto, and the number of color filters 320 or the number of pixels P corresponding to one micro lens 330 may be variously modified. In one aspect, an N x M array of color filters 320 may correspond to one micro lens 330. For example, when N and Mare 2, four color filters 320 may correspond to one micro lens 330.

In one aspect, an upper surface of the micro lens 330 may have a curved shape, unlike an upper surface of the color filter 320. However, it is not limited thereto, the upper surface of the micro lens 330 may have a rectangular shape with rounded corners. In another aspect, the upper surface of the color filter 320 may have a curved shape or a rectangular shape with rounded corners, similar to the upper surface of the micro lens 330.

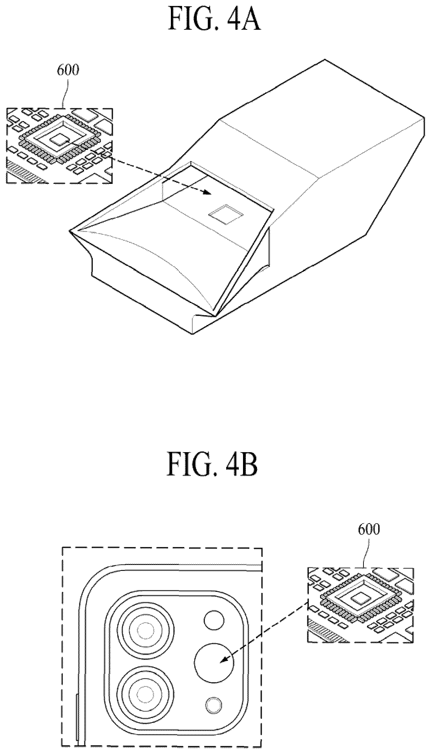

An image sensor 600 including the single-photon avalanche diode pixel array 200 according to one aspect of the present disclosure as illustrated in FIGs. 2 and 3 may be applied to an automotive lidar sensor as illustrated in FIG. 4A, or to a lidar sensor for a tablet PC or portable device as illustrated in FIG. 4B.

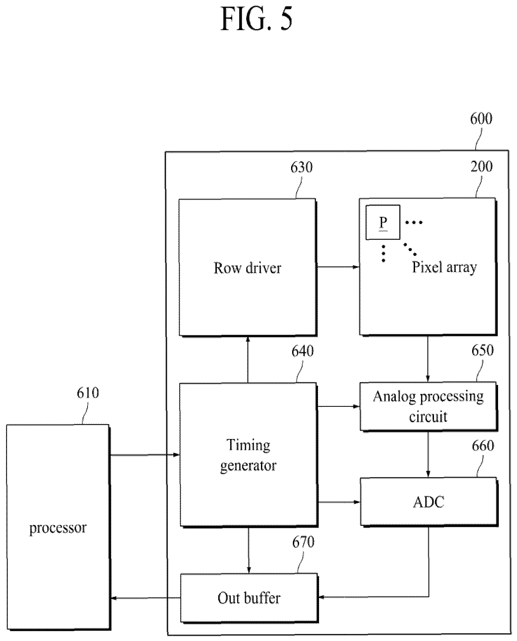

FIG. 5 is a block diagram of an image sensor having a single-photon avalanche diode pixel array as illustrated in FIG. 2 and FIG. 3. As illustrated in FIG. 5, the image sensor 600 including the single-photon avalanche diode pixel array 200 according to one exemplary aspect of the present disclosure emits an optical signal to an object, converts an optical signal reflected from the object into an electrical signal, and outputs the electrical signal to a processor 610 of an electronic device to which the image sensor 600 is applied.

In this aspect, the electronic device may include, in addition to the automotive lidar sensor, a lidar sensor for the tablet PC or the portable device, a camera, a wearable device, an Internet of Things IoT device, a home appliance, a robot, a robot vacuum cleaner, a portable multimedia player PMP, a navigation device, a drone, an Advanced Drivers Assistance System ADAS, etc. In addition, the electronic device may be an electronic device provided as a component in a vehicle, furniture, manufacturing equipment, a door, or various measuring devices.

As illustrated in FIG. 5, the image sensor 600 includes the single-photon avalanche diode pixel array 200, a row driver 630, a timing generator 640, an analog processing circuit 650, an analog-to-digital converter 660, and an output buffer 670.

The single-photon avalanche diode pixel array 200 includes a plurality of pixels P. The plurality of pixels P may be arranged two-dimensionally. For example, the plurality of pixels P may be arranged in a matrix form consisting of M (M is an integer greater than or equal to 2) rows and N (N is an integer greater than or equal to 2) columns. Each pixel P included in the single-photon avalanche diode pixel array 200 detects an optical signal using the single-photon avalanche diode and converts it into a pixel signal which is an electrical signal.

A detailed description for the single-photon avalanche diode pixel array 200 will be omitted because it has been described in the description of FIGS. 2 and 3.

Each pixel P may be driven by control signals received from the row driver 630. A signal converted by each pixel P and a reset signal corresponding to a reset component are inputted to the analog processing circuit 150.

The row driver 630 drives each pixel P included in the single-photon avalanche diode pixel array 200 based on the control of the timing generator 640. In one aspect, the row driver 630 may control all pixels P of the single-photon avalanche diode pixel array 200 simultaneously or control the pixels P of the single-photon avalanche diode pixel array 200 in a row unit. To this end, the row driver 630 may transmit control signal to the pixels P

In one aspect, the row driver 630 may transmit the control signal to each pixel P based on the control of the timing generator 640.

The timing generator 640 may control the single-photon avalanche diode pixel array 200 through the row driver 630 and output the control signal for controlling the analog processing circuit 650, the analog-to-digital converter 660, and the output buffer 670.

The analog processing circuit 650 may sample and hold an output signal provided from the pixel P according to a Correlated Double Sampling CDS method, and may double sample a specific noise level, such as a reset level and a signal level.

The analog processing circuit 650 may generate a comparison result signal corresponding to the reset level and a comparison result signal corresponding to the signal level. In this aspect, a method of reading out the signal level after reading out the reset level may be referred to as a complete CDS method, and a method of reading out the reset level after reading out the signal level may be referred to as an incomplete CDS method or a Delta Reset Sampling DRS method.

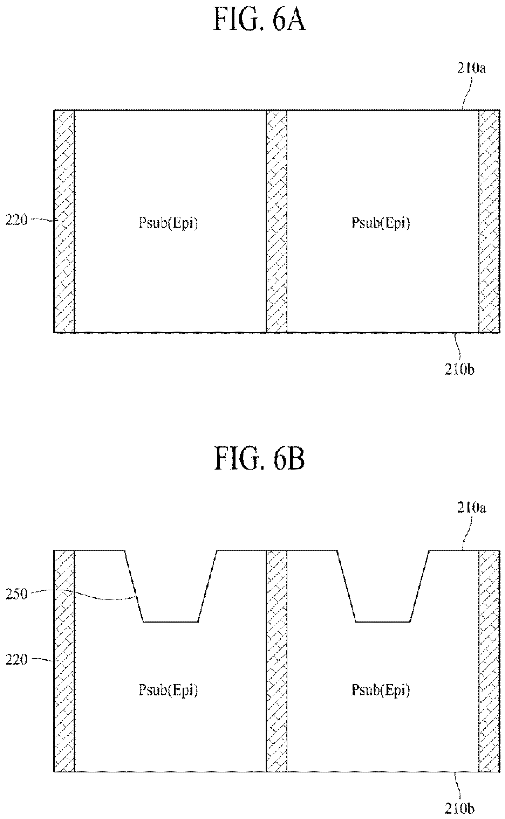

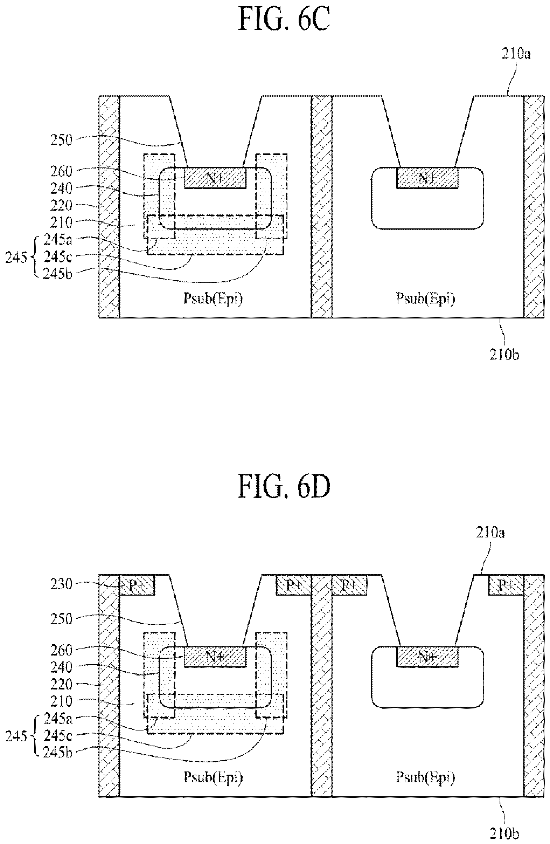

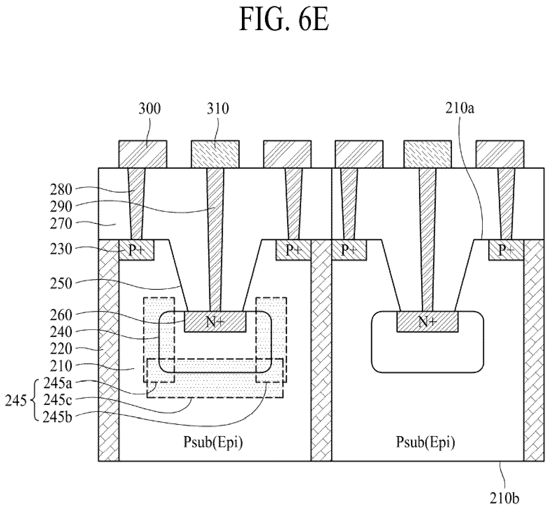

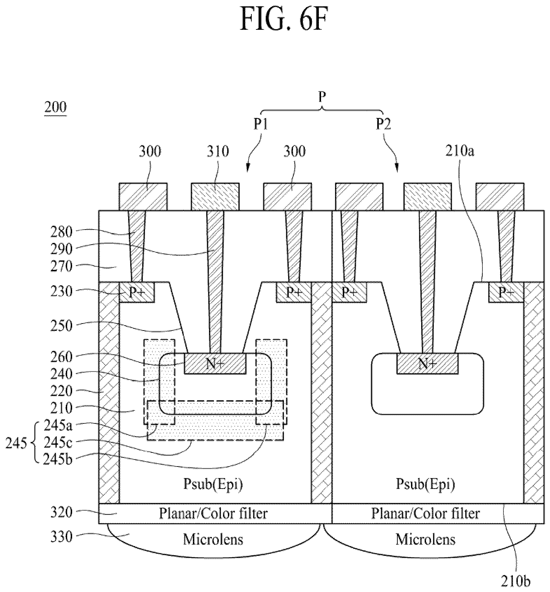

The analog-to-digital converter 660 may convert an output signal output from the analog processing circuit 650 into a digital signal and provide it to the output buffer 670. In FIG. 6, the analog processing circuit 650 and the analog-to-digital converter 660 are illustrated as independent components, but in another aspect, the analog-to-digital converter 660 may be included in or integrated with the analog processing circuit 650.

The output buffer 670 may latch the digital signal transmitted from the analog-to-digital converter 660 and sequentially output the latched signal.

The processor 610 of the electronic device may process the digital signal output from the output buffer 670 and output it to an external device or store it in a storage device such as memory.

Hereinafter, a method for manufacturing the single-photon avalanche diode pixel array according to one exemplary aspect of the present disclosure will be described with reference to FIG. 6.

FIG. 6A to FIG. 6F are process cross-sectional views showing a method for manufacturing a single-photon avalanche diode pixel array according to one exemplary aspect of the present disclosure.

As illustrated in FIG. 6A, the pixel isolation structure 220 for electrically isolating each pixel P is formed in the substrate 210 having the first surface 210a and the second surface 210b.

The substrate 210 is a region lowly doped with the first conductive type dopant or the second conductive type dopant, and may be formed by epitaxial growth. When the substrate 210 is doped with the first conductive type dopant, the substrate 210 forms the PN junction region together with the well region 240 formed by doping with the second conductive type dopant opposite to the first conductive type dopant in the substrate 210, and the PN junction region may be the avalanche multiplication region.

When the first conductive type dopant is a P-type dopant and the second conductive type dopant is an N-type dopant, the P-type dopant may include at least one of Boron, Aluminum, Gallium, and Indium, and the N-type dopant may include at least one of Phosphorus, Arsenic, and Stibium.

The pixel isolation structure 220 may be formed continuously from the first surface 210a of the substrate 210 toward the second surface 210b of the substrate 210. In one aspect, the pixel isolation structure 220 may be formed as a deep trench isolation DTI structure formed by filling an insulating layer in a deep trench formed by penetrating the substrate 210 from the first surface 210a of the substrate 210 toward the second surface 210b of the substrate 210.

According to the present disclosure, since the pixel isolation structure 220 for isolating each pixel P is formed continuously from the first surface 210a of the substrate 210 to the second surface 210b of the substrate 210, the occurrence of leakage current between adjacent pixels P may be prevented.

Thereafter, as illustrated in FIG. 6B, the trench 250 having a predetermined depth is formed within each pixel P. The trench 250 is formed to have a predetermined depth in the direction from the first surface 210a of the substrate 210 to the second surface 210b of the substrate 210, but is formed to a shorter depth than the pixel isolation structure 220.

Thereafter, as illustrated in FIG. 6C, the well region 240 is formed within the substrate 210 by lowly doping the second conductive type dopant opposite to the first conductive type dopant below the trench 250 within the substrate 210. The well region 240 may be formed in the substrate 210 to be spaced apart by a predetermined distance from the first highly doped region 230, which will be described later, toward the second surface 210b of the substrate 210. In this aspect, as described above, the region formed by doping the first conductive type dopant within the substrate 210 and the well region 240 formed by doping the second conductive type dopant form the PN junction, thereby forming the avalanche multiplication region 245.

That is, the first avalanche multiplication region 245a is formed at the first side 240a of the well region 240, the second avalanche multiplication region 245b is formed at the second side 240b facing the first side 240a, and the third avalanche multiplication region 245c is formed at the third side 240c connecting the first side 240a and the second side 240b.

The avalanche multiplication region 245 is a region where multiplication of electrons and holes occurs. In the avalanche multiplication region 245, a very strong electric field is formed in the reverse bias state, so that electrons may move quickly. Therefore, an electron-hole pair generated by a single photon generates additional electrons, and the generated electrons are accelerated by the electric field to collide with other atoms, and the process of generating additional electron-hole pairs occurs in a chain, thereby generating a very high current.

Due to the avalanche multiplication region 245, the single-photon avalanche diode is capable of single-photon detection, and thus may detect extremely low light signals, and may be particularly usefully applied to sensing in low-light environments.

Thereafter, as illustrated in FIG. 6D, the first highly doped region 230 is formed by highly doping with the first conductive type dopant at the first surface 210a of the substrate 210, and the second highly doped region 260 is formed at the surface of the well region 240 exposed by the trench 250 by highly doping the second conductive type dopant.

The first highly doped region 230 may be formed with a predetermined thickness below the first surface 210a of the substrate 210, and the second highly doped region 260 may be formed with a predetermined thickness between the trench 250 and the first surface 210a of the substrate 210.

The first highly doped region 230 may form an anode region of the single-photon avalanche diode, and the second highly doped region 260 may form a cathode region of the single-photon avalanche diode.

In the single-photon avalanche diode pixel array 200 according to one aspect of the present disclosure, the second highly doped region 260 forming the cathode region is formed by highly doping the second conductive type dopant at the surface of the well region 240 exposed by the trench 250 formed through selective etching of the substrate 210, so that the second highly doped region 260 forming the cathode region and the first highly doped region 230 forming the anode region are arranged in a vertical structure.

Accordingly, in the single-photon avalanche diode pixel array 200 according to one aspect of the present disclosure, a guard ring required for isolation of the anode region and the cathode region in a general single-photon avalanche diode is not required, so that pixel miniaturization is possible.

In the above-described aspect, the position at which the second highly doped region 260 is formed within the substrate 210 may be adjusted according to the depth of the trench 250. In this aspect, the deeper the depth of the trench 250, the further the second highly doped region 260 may be formed from the first highly doped region 230, and the shallower the depth of the trench 250, the closer the second highly doped region 260 may be formed from the first highly doped region 230.

The depth of the trench 250 may be determined to be inversely proportional to the pitch of each pixel P. In this aspect, as the pitch of the pixel P decreases, the vertical distance between the first highly doped region 230 and the second highly doped region 260 has to increase, and thus the depth of the trench 250 is formed deep. On the contrary, as the pitch of each pixel P increases, the vertical distance between the first highly doped region 230 and the second highly doped region 260 may decrease, and thus the depth of the trench 250 may be formed shallow.

In one aspect, the first highly doped region 230 may be formed to be surrounded by the pixel isolation structure 220 in a plan view, and the second highly doped region 260 may be formed to be surrounded by the first highly doped region 230. In this aspect, the pixel isolation structure 220 formed in the substrate 210 may be formed in a closed loop shape that surrounds the first highly doped region 230 in a plan view, and the first highly doped region 230 may be formed in a closed loop shape that surrounds the second highly doped region 260 in a plan view.

In the above-described aspect, the well region 240, the first highly doped region 230, and the second highly doped region 260 may be formed using ion implant technology.

In FIG. 6C and FIG. 6D, the second highly doped region 260 is formed first, and then the first highly doped region 230 is formed. However, it is not limited thereto. For example, the first highly doped region 230 and the second highly doped region 260 may be formed simultaneously, or the first highly doped region 230 may be formed first, and then the second highly doped region 260 may be formed.

Thereafter, as shown in FIG. 6E, the insulating layer 270 is formed on the first surface 210a of the substrate 210 and inside the trench 250, and the first contact hole CT1 exposing the first highly doped region 230 and the second contact hole CT2 exposing the second highly doped region 260 are formed by penetrating the insulating layer 270.

In addition, a metal material is filled into the first contact hole CT1 to form the first contact portion 280 electrically connected to the first highly doped region 230, and a metal material is filled into the second contact hole CT2 to form the second contact portion 290 electrically connected to the second highly doped region 260.

In addition, the first metal pad 300 is formed on the first contact portion 280 to electrically connect the first contact portion 280 and the driving circuit of the image sensor, and the second metal pad 310 is formed on the second contact portion 290 to electrically connect the second contact portion 290 and the driving circuit. The first contact portion 280 and the first metal pad 300 form the anode electrode unit, and the second contact portion 290 and the second metal pad 310 form the cathode electrode unit.

In this aspect, the driving circuit may be a quench circuit or an output circuit (ROIC: Read Out Integrated Circuit). The quench circuit is used to cut off the avalanche effect and reset the single-photon avalanche diode pixel. The output circuit receives and transmits the signal current.

Thereafter, as shown in FIG. 6F, the color filter 320 and the micro lens 330 are formed for each pixel P1 and P2 on the first surface 210b of the substrate 210.

The color filter 320 may be color filter of different colors for each pixel P. For example, the color filter of the first pixel P1 may be a red color filter, and the color filter of the second pixel P2 may be a green color filter.

However, it is not limited thereto, and the number of pixels corresponding to one color filter 320 may be variously modified. For example, pixels in an N x M array (N and M are integers greater than 1) may correspond to one color filter 320.

The micro lens 330 is arranged on each color filter 320. The micro lens 330 is disposed on the color filter 320 and collect light incident from the outside. The micro lens 330 may be arranged to correspond to each pixel P. In this aspect, one micro lens 330 may be arranged on one pixel P. For example, when one color filter 320 is arranged to correspond to one pixel P, the ratio of the number of color filters 320 to the number of micro lenses 330 may be 1: 1.

However, it is not limited thereto, and the number of color filters 320 or the number of pixels P corresponding to one micro lens 330 may be variously modified. In one aspect, an N x M array of color filters 320 may correspond to one micro lens 330.

In one aspect, an upper surface of the micro lens 330 may have a curved shape, unlike an upper surface of the color filter 320. However, it is not limited thereto, the upper surface of the micro lens 330 may have a rectangular shape with rounded corners. In another aspect, the upper surface of the color filter 320 may have a curved shape or a rectangular shape with rounded corners, similar to the upper surface of the micro lens 330.

In the present disclosure, by arranging the cathode region and the anode region in a vertical structure, a guard ring between the cathode region and the anode region is not required, so that the pixel size of the single-photon avalanche diode may be reduced.

In addition to, in the present disclosure, since the pixel isolation structure for isolating pixels from each other is formed continuously from the first surface to the second surface of the substrate, the occurrence of leakage current between pixels may be prevented.

The above-described feature, structure, and effect of the present disclosure are included in at least one aspect of the present disclosure, but are not limited to only one aspect. Furthermore, the feature, structure, and effect described in at least one aspect of the present disclosure may be implemented through combination or modification of other aspects by those skilled in the art. Therefore, content associated with the combination and modification should be construed as being within the scope of the present disclosure.

It will be apparent to those skilled in the art that various modifications and variations may be made in the present disclosure without departing from the spirit or scope of the disclosures. Thus, it is intended that the present disclosure covers the modifications and variations of this disclosure.

The various aspects described above may be combined to provide further aspects. [Note: essential matter cannot be incorporated by reference from foreign patents, foreign patent application or non-patent publications; however, the U. S. PTO should allow the improperly incorporated subject matter to be expressly added to the specification by way of amendment without affecting the filing date. The ability to incorporate by reference to the ADS is untested. We strongly encourage you to explicitly list those references you wish to incorporate by reference at the appropriate location within the sentence.]

These and other changes may be made to the aspects in light of the above-detailed description. In general, in the following claims, the terms used should not be construed to limit the claims to the specific aspects disclosed in the specification and the claims, but should be construed to include all possible aspects along with the full scope of equivalents to which such claims are entitled. Accordingly, the claims are not limited by the disclosure.

## Claims

1. A single-photon avalanche diode pixel array comprising:
a substrate doped with a first conductive type dopant and having a plurality of pixels formed thereon;
a pixel isolation structure for electrically isolating the plurality of pixels from each other;
a first highly doped region provided by highly doping the first conductive type dopant at a first surface of the substrate;
a trench disposed to have a predetermined depth from the first surface of the substrate toward a second surface of the substrate;
a well region provided below the trench to be spaced apart from the first highly doped region by a predetermined distance and provided by doping a second conductive type dopant opposite to the first conductive type dopant to form an avalanche multiplication region; and
a second highly doped region formed by highly doping the second conductive type dopant at a surface of the well region exposed by the trench.

2. The single-photon avalanche diode pixel array according to claim 1, wherein the first highly doped region is an anode region of a single-photon avalanche diode and the second highly doped region is a cathode region of the single-photon avalanche diode.

3. The single-photon avalanche diode pixel array according to claim 2, further comprising:
an insulating layer disposed on the first surface of the substrate and inside the trench;
an anode electrode unit having one end connected to the anode region through the insulating layer and the other end connected to a driving circuit for driving an image sensor; and
a cathode electrode unit having one end connected to the cathode region through the insulating layer and the other end connected to the driving circuit,
wherein the anode electrode unit and the cathode electrode unit comprise:
a contact portion filled inside a contact hole formed by penetrating the insulating layer; and
a metal pad electrically connected to the contact portion.

4. The single-photon avalanche diode pixel array according to any of the preceding claims, wherein the pixel isolation structure extends from the first surface of the substrate to the second surface of the substrate.

5. The single-photon avalanche diode pixel array according to any of the preceding claims, wherein the length of the pixel isolation structure is longer than the length of the trench.

6. The single-photon avalanche diode pixel array according to any of the preceding claims, wherein the first conductive type dopant is a P-type dopant and the second conductive type dopant is an N-type dopant.

7. The single-photon avalanche diode pixel array according to any of the preceding claims, wherein the depth of the trench is inversely proportional to the pitch of each pixel.

8. The single-photon avalanche diode pixel array according to any of the preceding claims, wherein the first highly doped region has a closed loop shape surrounding the trench, the well region, and the second highly doped region in a plan view, and
wherein the pixel isolation structure has a closed loop shape surrounding the first highly doped region in a plan view.

9. A method for fabricating a single-photon avalanche diode pixel array, the method comprising:
forming a pixel isolation structure for electrically isolating the plurality of pixels from each other in a substrate, the substrate being doped with a first conductive type dopant;
forming a trench to have a predetermined depth from a first surface of the substrate toward a second surface of the substrate;
forming a well region between a bottom surface of the trench and the second surface of the substrate by doping a second conductive type dopant opposite to the first conductive type dopant to form an avalanche multiplication region; and
forming a first highly doped region by highly doping the first conductive type dopant at the first surface of the substrate and forming a second highly doped region by highly doping the second conductive type dopant at a surface of the well region exposed by the trench.

10. The method according to claim 9, wherein the first highly doped region is an anode region of a single-photon avalanche diode and the second highly doped region is a cathode region of the single-photon avalanche diode.

11. The method according to claim 9 or 10, further comprising:
forming an insulating layer on the first surface of the substrate and inside the trench;
forming a first contact portion connected to the first highly doped region through the insulating layer and a second contact portion connected the second highly doped region through the insulating layer; and
forming a first metal pad connecting the first contact portion to a driving circuit for driving an image sensor and forming a second metal pad connecting the second contact portion to the driving circuit.

12. The method according to any of claims 9 to 11, wherein the pixel isolation structure extends from the first surface of the substrate to the second surface of the substrate.

13. The method according to any of claims 9 to 12, wherein the length of the pixel isolation structure is longer than the length of the trench.

14. The method according to any of claims 9 to 13, wherein the first conductive type dopant is a P-type dopant and the second conductive type dopant is an N-type dopant.

15. The method according to any of claims 9 to 14, wherein the depth of the trench is inversely proportional to the pitch of each pixel.
